(19) Europäisches Patentamt

European Patent Office

Office européen des brevets

(11) **EP 1 494 293 A2**

(12) **DEMANDE DE BREVET EUROPEEN**

(43) Date de publication:
**05.01.2005 Bulletin 2005/01**

(51) Int Cl.⁷: **H01L 31/0232**

(21) Numéro de dépôt: **04364045.7**

(22) Date de dépôt: **28.06.2004**

(84) Etats contractants désignés:
**AT BE BG CH CY CZ DE DK EE ES FI FR GB GR
HU IE IT LI LU MC NL PL PT RO SE SI SK TR**
Etats d'extension désignés:
**AL HR LT LV MK**

(30) Priorité: **03.07.2003 FR 0308140**

(71) Demandeur: **Optogone**
**29280 Plouzané (FR)**

(72) Inventeurs:
• **Verbrugge, Vivien**
**35000 Rennes (FR)**
• **Plouzennec, Loig**
**2566 NE, La Haye (NL)**
• **De Bougrenet De La Tocnaye, Jean-Louis**
**29820 Guilers (FR)**

(74) Mandataire: **Vidon, Patrice**
**Cabinet Vidon**
**16 B, rue Jouanet - B.P. 90333**
**35703 Rennes Cedex 7 (FR)**

(54) **Photodétecteur à cavité verticale résonnante, matrice et système de télécommunication correspondant**

(57)    L'invention concerne un photodétecteur (10, 60) à cavité verticale résonnante comprenant un premier (20) et un second (21) moyens de réflexion formant ladite cavité et des moyens d'absorption (22) de photons d'un faisceau lumineux incident (17), caractérisé en ce qu'il comprend, en outre, à l'intérieur de ladite cavité, au moins un élément électro-optique destiné à accorder la longueur d'onde dudit photodétecteur.

L'invention concerne également une matrice de plusieurs photodétecteurs et un système de télécommunication correspondant.

**Fig. 2**

## Description

### Domaine de l'invention.

La présente invention se rapporte au domaine des composants optiques, et plus précisément des photodétecteurs à cavité verticale résonante (ou CVR ou encore RCE de l'anglais « Resonant Cavity Enhanced »).

### Etat de l'art.

Les photodétecteurs RCE sont notamment décrits dans l'article « Design of a resonant cabity enhanced photodetector for high speed application » (ou « Conception d'un photodétecteur CVR pour des applications à haut débit » en français ») écrit par Tung et Lee et publié dans la revue IEEE Journal of quantum electronics en mai 1997. Les photodétecteurs RCE présentent plusieurs avantages par rapport aux autres photodétecteurs. Ils ont d'abord de meilleurs rendements quantiques externes et une large bande passante. Ils présentent également du gain lorsqu'ils sont utilisés en régime avalanche.

Un inconvénient des photodétecteurs RCE selon l'état de l'art est qu'ils ne peuvent détecter qu'une seule longueur d'onde, cette dernière ne dépendant que du mode de fabrication.

### Objectifs de l'invention.

L'invention selon ses différents aspects a notamment pour objectif de pallier ces inconvénients de l'art antérieur.

Plus précisément, un objectif de l'invention est de fournir un photodétecteur accordable en fonction de la longueur d'onde que l'on souhaite détecter.

De plus, un objectif de l'invention est de permettre au photodétecteur de se caler de manière précise sur des canaux qui peuvent dériver naturellement dans le temps et/ou varier suite à des changements d'émetteur ou de sa longueur d'onde.

Un autre objectif de l'invention est de fournir un photodétecteur relativement simple à fabriquer.

Encore un autre objectif de l'invention est de permettre une vitesse de photodétection élevée compatible avec de nombreuses applications (notamment des applications de transfert de données à haut-débit) ainsi qu'une grande sensibilité.

### Présentation de l'invention.

Dans ce but, l'invention propose un photodétecteur à cavité verticale résonnante comprenant un premier et un second moyens de réflexion formant la cavité et des moyens d'absorption de photons d'un faisceau lumineux incident, le photodétecteur comprenant, en outre, à l'intérieur de la cavité, au moins un élément électro-optique destiné à accorder la longueur d'onde du photodétecteur.

Selon une caractéristique particulière, le photodétecteur est remarquable en ce qu'il comprend, en outre, des premiers moyens d'application d'un champ électrique variable à l'élément électro-optique en fonction d'au moins une tension électrique appliquée au photodétecteur.

Ainsi, on peut accorder de manière simple le photodétecteur en fonction d'une longueur d'onde à détecter.

Selon une caractéristique particulière, le photodétecteur est remarquable en ce que les premiers moyens d'application d'un champ électrique comprennent au moins une première électrode transparente ou semi-transparente permettant l'application du champ électrique aux éléments électro-optiques et le passage du faisceau lumineux incident au travers de ces électrodes.

Ainsi, le ou les faisceaux lumineux reçus par le photodétecteur peuvent traverser les électrodes, celles-ci étant par ailleurs adaptées à créer un champ électrique approprié dans le ou les éléments électro-optiques.

Selon une caractéristique particulière, le photodétecteur est remarquable en ce que la ou les premières électrodes sont de type ITO.

Ainsi, le photodétecteur est relativement compact et simple à réaliser.

Selon une caractéristique particulière, le photodétecteur est remarquable en ce qu'au moins un des éléments électro-optiques comprend un matériau isotrope dans un plan transverse.

On note que « plan transverse » s'entend ici comme un plan perpendiculaire à un axe de propagation du ou des faisceaux lumineux reçus par le photodétecteur et traversant le plan.

Un «matériau isotrope » signifie ici un matériau isotrope à la ou aux longueurs d'ondes considérées (c'est-à-dire à la ou les longueurs d'ondes reçues par le photodétecteur).

Le matériau est isotrope dans un plan transverse ce qui est suffisant pour avoir un photodétecteur présentant un comportement insensible à la polarisation.

Selon une caractéristique particulière, le photodétecteur est remarquable en ce qu'au moins un des éléments électro-optiques comprend un matériau de type nano-PDLC.

Ainsi, on dispose de manière avantageuse d'un matériau présentant de bonnes caractéristiques optiques, et facile à mettre en oeuvre, par exemple par dépôt et gravure.

Selon une caractéristique particulière, le photodétecteur est remarquable en ce que les moyens d'absorption de photons comprennent une zône absorbante massive.

Selon une caractéristique particulière, le photodétecteur est remarquable en ce qu'il comprend des seconds moyens d'application d'un champ électrique à la zone absorbante.

Ainsi, le photodétecteur met en oeuvre des seconds moyens d'application d'un champ électrique à la zone absorbante de manière à ce que la détection soit plus efficace et plus fiable et ne nécessite pas de moyens externes d'amplification.

Selon l'invention, les premiers et seconds moyens d'application d'un champ électrique peuvent comprendre des parties communes. Ainsi, selon un mode préférentiel de réalisation de l'invention, ils comprennent une première électrode (par exemple transparente, semi-transparente ou annulaire) commune, soumise à un potentiel électrique (par exemple à la masse), ce qui simplifie la mise en oeuvre du photodétecteur et diminue son encombrement.

Selon des modes particuliers de réalisation de l'invention, les seconds moyens d'application d'un champ électrique comprennent également une électrode permettant la détection photoélectrique. Cette électrode est, par exemple en or et est, préférentiellement, accolée à des moyens de réflexion (pour simplifier la mise en oeuvre et limiter l'encombrement du photodétecteur).

Selon une caractéristique particulière, le photodétecteur est remarquable en ce que le ou les éléments optiques possèdent un profil de perte optique variable dans un plan perpendiculaire à un axe de propagation du faisceau lumineux de sorte à favoriser un mode transverse du photodétecteur.

Ainsi, le photodétecteur est adapté à recevoir et à détecter des faisceaux selon des modes transverses particuliers : mode transverse fondamental ou premier mode transverse, notamment. On obtient, de cette manière, une meilleure immunité au bruit si le faisceau reçu à décoder fonctionne sur un seul mode transverse. Ce profil permet donc de favoriser soit le mode transverse fondamental soit un autre mode d'une manière souple et simple à réaliser.

L'invention concerne également une matrice de composants comprenant au moins deux photodétecteurs tels que décrits précédemment selon l'invention.

Ainsi, l'invention permet d'obtenir des composants photodétecteurs à faible coût ou des composants de petite taille, aptes à traiter un faisceau incident à plusieurs longueurs d'ondes.

Selon une caractéristique particulière, la matrice de composants est remarquable en ce que chaque photodétecteur de la matrice comprend :

- des moyens d'application d'un champ électrique permettant d'accorder une longueur d'onde associée au photodétecteur, de sorte que la matrice est apte à accorder une pluralité de longueurs d'onde ;
- et des moyens de détection associés à chacune des longueurs d'onde accordées.

Ainsi, la matrice permet de recevoir un faisceau à plusieurs longueurs d'ondes et à traiter séparément chacune des longueurs d'onde d'une manière souple (l'accordabilité et donc la longueur d'onde détectée pouvant évoluer à la demande) et simple à mettre en oeuvre (associer le photodétecteur à une longueur d'onde particulière revenant à choisir de manière adéquate le champ électrique appliqué au photodétecteur correspondant de la matrice).

En outre, l'invention concerne un système de télécommunications à haut débit, reamarquable en ce qu'il comprend des moyens de réception d'au moins un faisceau incident comprenant eux-mêmes au moins un photodétecteur à cavité verticale résonnante, tel que décrit précédemment.

Selon une caractéristique particulière, le système est remarquable en ce que les moyens de réception comprennent des moyens de redirection d'un faisceau incident vers chacun des photodétecteurs.

Ainsi, les photodétecteurs peuvent être utilisés en parallèle, ce qui est particulièrement utile pour les applications à hauts débits.

Selon une caractéristique particulière, le système est remarquable en ce que les moyens de redirection forment un coupleur.

Selon une caractéristique particulière, le système est remarquable en ce que les moyens de réception comprennent au moins deux photodétecteurs adaptés à détecter des faisceaux lumineux de longueurs d'onde distinctes.

Selon une caractéristique particulière, le système est remarquable en ce qu'il comprend des moyens d'émission du ou des faisceaux incidents.

Les avantages de la matrice et du système de photodétection sont les mêmes que ceux du photodétecteur, ils ne sont pas détaillés plus amplement.

**Liste des figures.**

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente une vue générale en perspective d'un photodétecteur, conforme à l'invention selon un mode particulier de réalisation ;
- les figures 2, 3A et 3B illustrent un schéma de principe du photodétecteur de la figure 1 ;
- les figures 4A, 4B et 4C présentent un procédé de fabrication du photodétecteur des figures précédentes ;
- la figure 5 illustre des spectres de rendement quantique du photodétecteur présenté en regard de la figure 1 ; et
- la figure 6 illustre un système de communication mettant en oeuvre des photodétecteurs tels que présentés dans les figures précédentes.

Le principe général de l'invention repose sur l'utilisation dans un photodétecteur d'une zone de phase variable permettant ainsi d'accorder la longueur d'onde du photodétecteur. Cette zone de phase variable peut, par exemple, être obtenue par application d'un champ électrique sur une cavité remplie de nano-PDLC. Le champ électrique peut notamment être obtenue grâce à une électrode transparente de type ITO ou grâce à une électrode circulaire.

**Description selon un mode de réalisation préférentiel de l'invention.**

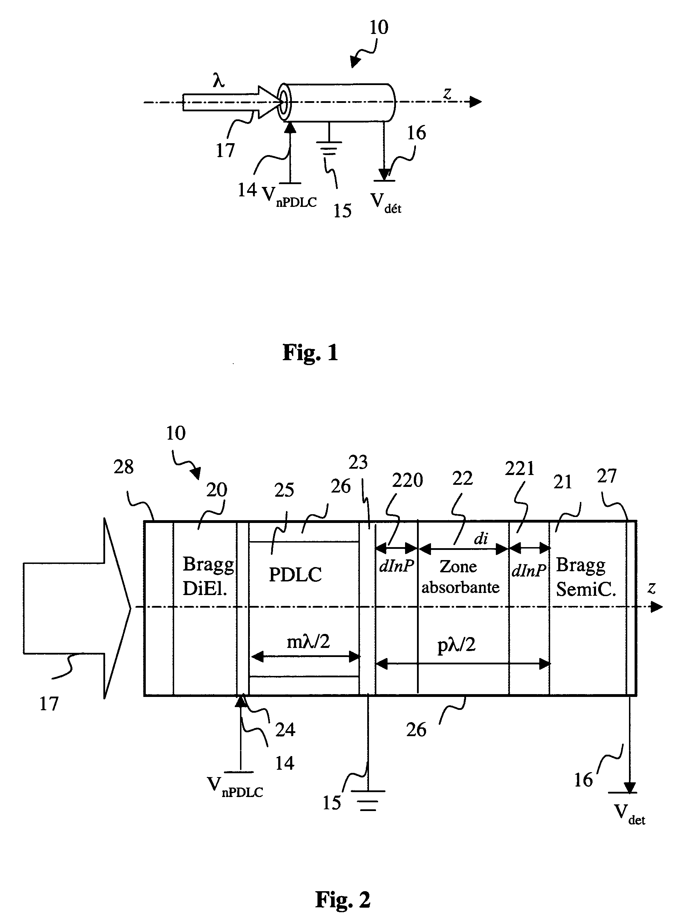

On présente schématiquement (les échelles n'étant pas respectées), en relation avec la **figure 1**, un mode préféré de réalisation d'un photodétecteur accordable RCE 10 destiné à recevoir un faisceau optique 17 de longueur d'onde $\lambda$.

On note que le photodétecteur 10 est soumis à différents potentiels électriques :

- un point 16 est soumis à un potentiel de détection $V_{dét}$ du faisceau lumineux 17 ;
- un point 14 est soumis à un potentiel $V_{nPDLC}$ qui permet d'accorder la longueur d'onde de détection du photodétecteur 10 ; et
- un point 15 est soumis à un potentiel nul.

La différence de potentiel de détection $V_{dét}$ est appliquée entre les points 15 et 16 pour polariser le coté photodétecteur et permet notamment d'accélérer les paires électrons-trous permettant la photodétection.

Le photodétecteur 10 est adapté à recevoir un faisceau optique 17 de longueur d'onde $\lambda$ suivant un axe z de propagation, le photodétecteur 10 étant, préférentiellement, sensiblement à symétrie axiale autour de cet axe. Ce faisceau peut être reçu en espace libre ou à partir d'une ou de plusieurs fibres optiques associées au photodétecteur 10.

Selon une autre variante de l'invention permettant notamment de réaliser une matrice de photodétecteurs pour former un composant détectant des longueurs d'ondes distinctes ou plusieurs composants séparés, les points 14 et 16 sont soumis à plusieurs potentiels respectivement $VnPDLC\lambda_1$, $VnPDLC\lambda2$, ... $VnPDLC\lambda i$, $VnPDLC\lambda n$ et $Vdét\lambda1$, $Vdét\lambda2$, ... $Vdét\lambda i$, .. $Vdét\lambda n$. Chacun de ces potentiels est relié à une électrode respectivement d'ITO gravée sur un substrat (par exemple en verre transparent) et d'or déposée sur un miroir de Bragg, perpendiculaire à l'axe du photodétecteur 10 et sont associé à une longueur d'onde de détection particulière. Ainsi, une électrode au potentiel $VnPDLC\lambda i$ et une électrode située en face (suivant la direction z) au potentiel $Vdét\lambda i$ permettent respectivement d'accorder une zone de phase variable à la longueur d'onde $\lambda i$ et de polariser la zone de détection correspondante du photodétecteur 10. Les potentiels $Vdét\lambda i$ prennent une valeur qui dépend de la structure du photodétecteur et sont préférentiellement identiques (de l'ordre de -10V correspondant à la tension d'avalanche).

Si un composant comprenant plusieurs électrodes détecte plusieurs longueurs d'ondes distinctes, les faisceaux en entrée peuvent alors, notamment, être reçus à partir de différentes fibres optiques. L'ensemble des électrodes peut notamment former un pavage sur le substrat ou le miroir de Bragg de sorte à optimiser le nombre d'électrodes en fonction de la surface disponible ; ainsi, selon l'invention, on peut réaliser un substrat ou un miroir de Bragg sur lesquels sont imprimées neuf électrodes réparties régulièrement dans une matrice de trois rangées comprenant chacune trois électrodes.

La **figure 2** illustre schématiquement de principe du photodétecteur 10 tel qu'illustré en regard de la figure 1, sous la forme d'une coupe longitudinale.

Le photodétecteur 10 comprend une cavité fermée par deux miroirs de Bragg :

- un miroir de Bragg 21 semiconducteur à 44,5 paires dont les éléments sont respectivement d'indices à 3,41 et 3,16 à une longueur d'onde égale à 1,55 $\mu$m, en respectivement quaternaire 1,45 $\mu$m (noté Q1,45) et InP, une électrode 27 en or étant déposée sur le miroir 21 (un Bragg semiconducteur étant plus simple à réaliser qu'un Bragg diélectrique, la zone active, le Bragg lui-même pouvant être fabriqué en une seule étape correspondant à des dépôts successifs et répétés d'une couche d'InP et de quaternaire 1,45 $\mu$m); et
- un miroir Bragg diélectrique 20 de type DBR en SiO$_2$ et TiO$_2$ à 3,5 paires d'indice respectifs 1,46 et 2,23 à 1,55 $\mu$m et accolé à un substrat transparent 28.

Les miroirs 20 et 21 sont perpendiculaires à l'axe longitudinal z de réception du faisceau lumineux 17 (en d'autres termes, ils sont dans un plan transverse).

La détection du faisceau 17 se fait par l'électrode à laquelle on applique le potentiel $Vdét$, un courant proportionnel à la quantité de lumière incidente étant créé. Le substrat 28 permet la réception du faisceau 17 par le biais d'optiques appropriées (par exemple, des micro-lentilles de couplage).

Ainsi, les miroirs Bragg 20 et 21 sont calculés pour être très réflectifs à 1,55 $\mu$m (99,7% de réflexibilité pour le Bragg 20 et 99,8% pour le miroir 21)

La cavité comprend, quant à elle, des éléments successifs suivants :

- une zone absorbante 22 (massive ou « bulk » en anglais) en InGaAs (Indium Gallium Arsenic) d'indice 3,3, de coefficient d'absorption $\alpha$ valant 1,2 $\mu$m$^{-1}$

et d'épaisseur *di* égale à 25 nm prise en sandwich entre deux zones neutres 220 et 221 en InP d'indice égal à 3,16 et d'épaisseur *dInP* valant 110 nm ;

- une première électrode 23 en or reliée au potentiel électrique nul 15 ;
- une zone 25 de phase variable contenant un cristal liquide de type nano-PDLC, la zone 25 étant fermée sur les cotés par une couche 26 de polyimide ; et
- une électrode 24 de type ITO perpendiculaire à l'axe z relié au potentiel $V_{nPDLC}$ accolée au miroir 20.

La zone 25 de phase variable a un indice voisin de 1,55 et une longueur d'environ 1 $\mu$m, fonction de la longueur d'onde $\lambda$.

Les électrodes 23 et 24 sont prises suffisamment peu épaisses (par exemple 10 nm) pour être considérées comme transparentes.

L'application d'un champ électrique variable *E* créé par la différence de potentiel entre les électrodes 23 et 24 et appliqué parallèlement à la direction de propagation du faisceau lumineux (selon l'axe *z* du photodétecteur 10) à la zone 25 de phase variable permet d'accorder la longueur d'onde de résonance de la cavité. On peut ainsi obtenir une variation de la longueur d'onde de détection du photodétecteur de 20 nm autour de 1,55 $\mu$m pour un potentiel $V_{nPDLC}$ égal à 100 Volts.

La faiblesse de la réflexion à l'interface semiconducteur/nano-PDLC permet de s'affranchir du recours au traitement anti-reflet qui compliquerait la structure et réduirait le facteur de recouvrement longitudinal pour une même longueur de cavité et de zone de déphasage.

Pour certains modes de réalisation, on peut cependant prévoir d'avoir recours à un traitement anti-reflet.

Les nombres de paires des miroirs sont calculés de sorte à ce que la largeur à mi-hauteur de l'efficacité quantique externe soit assez faible et à ce que leur réflectivités vérifient à peu près la relation maximisant le rendement quantique externe, soit : $R_1 = R2 \exp(-2\alpha_{eff}.di)$ où $\alpha_{eff}$ est égal au produit $\alpha S$, $\alpha$ représentant le coefficient d'absorption de l'InGaAs et *S* étant un parametre tenant compte de l'effet de champ stationnaire (la zone absorbante étant située sur un maxima de champ stationnaire, la valeur de *S* est estimée à 1). L'ajustement de l'épaisseur de la couche d'InGaAs permet de satisfaire plus précisément à la relation précédente.

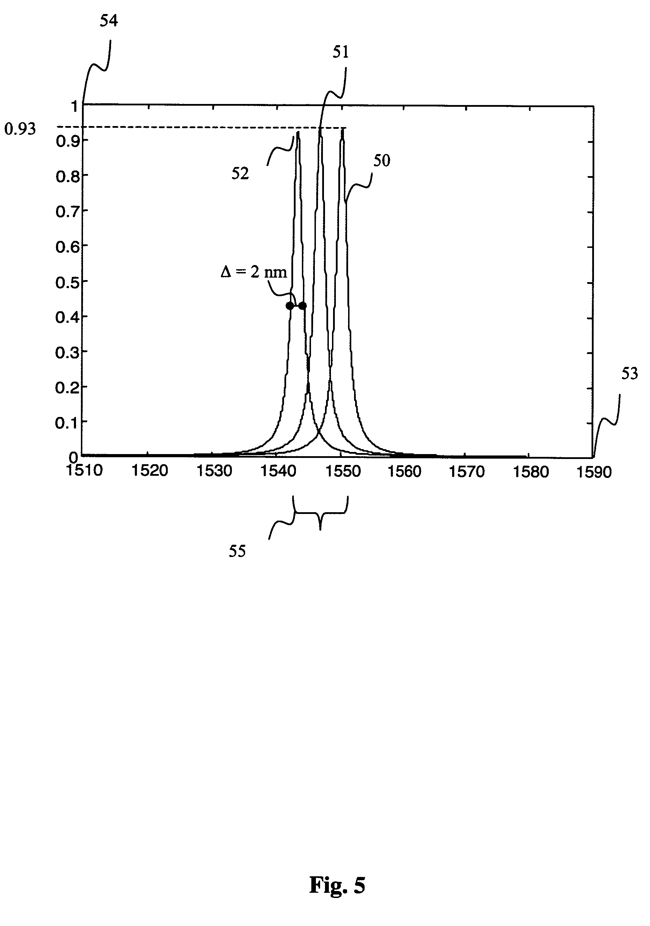

La **figure 5** illustre le spectre du rendement quantique externe 54 du photodétecteur 10 en fonction de la longueur d'onde 53 (exprimée en nm) pour différentes tensions $V_{nPDLC}$ de polarisation de la zone de phase variable 25 égales respectivement à 0 V, 21 V et 45 V correspondant respectivement aux courbes 50, 51 et 52. Le rendement quantique externe 54 est calculé à l'aide de la méthode des matrices de transfert. Les tensions $V_{nPDLC}$ 0 V, 21 V et 45 V appliquée pour polariser la zone 25 entraîne une détection de lumière respectivement aux longueurs d'ondes centrales égales à 1555 nm, 1550 nm et 1545 nm avec une bande passante de 2 nm.

Le coefficient d'absorption de l'InGaAs $\alpha$ est considéré constant en fonction de la longueur d'onde car il ne varie que très peu sur la plage d'accordabilité de la cavité. Les coefficients de pertes des autres couches de semiconducteur de la structure sont négligeables devant $\alpha$. Le coefficient de pertes dans la couche de nano PDLC décroît en fonction de la tension appliquée de 15 $10^{-4}$ $\mu m^{-1}$ à 3 $10^{-4}$ $\mu m^{-1}$. Il est aussi négligeable devant $\alpha$. Un rendement quantique d'environ 93% avec une bande passante $\Delta$ à mi-hauteur d'environ 2 nm sont obtenus sur toute la bande d'accordabilité 55 de la cavité comprise entre 1545 et 1555 nm. Les faibles variations du rendement quantique (variations dues aux variation des réflectivités des miroirs de Bragg) en fonction de la tension appliquée sont dues essentiellement à celles des réflectivités des miroirs en fonction de la longueur d'onde de résonance.

Sous réserve de polariser le photodétecteur 10 en inverse avec une tension proche de la tension de claquage (ici de l'ordre de quelques dizaines de volts et dépendant de la structure du photodétecteur dans le cas général) permettant un régime avalanche, il présente du gain. Ce gain est quantifié à l'aide du facteur de multiplication M en régime avalanche. Ce régime de multiplication donne lieu à un processus d'amplification interne du photocourant. Ceci permet de réduire les contraintes sur un circuit électronique externe d'amplification ce qui permet de limiter l'augmentation du coût, de l'encombrement du système et l'impact sur la bande passante.

Par ailleurs, pour une aire du photodétecteur 10 suffisamment faible, sa bande passante $[0, f_{tr}]$ est déterminée par la fréquence de coupure (fréquence à laquelle on perd 3dB sur le signal de sortie) liée au temps de transit des porteurs dans la zone absorbante 22. Son expression est donnée par la relation :

$$f_{tr} = 0,45 \frac{(v_h)}{d_i + 2\,d_{InP}}$$

où $v_h$ est la vitesse de déplacement des trous (porteurs les plus lents) dans la zone absorbante.

Ainsi, la fréquence de coupure théorique est de d'environ 100GHz dans le cas d'un champ électrique appliqué à la zone semiconductrice de la cavité par le biais de $V_{dét}$ saturant la vitesse des trous à $10^7$ cm/s.

**Réalisation des différentes parties du composant.**

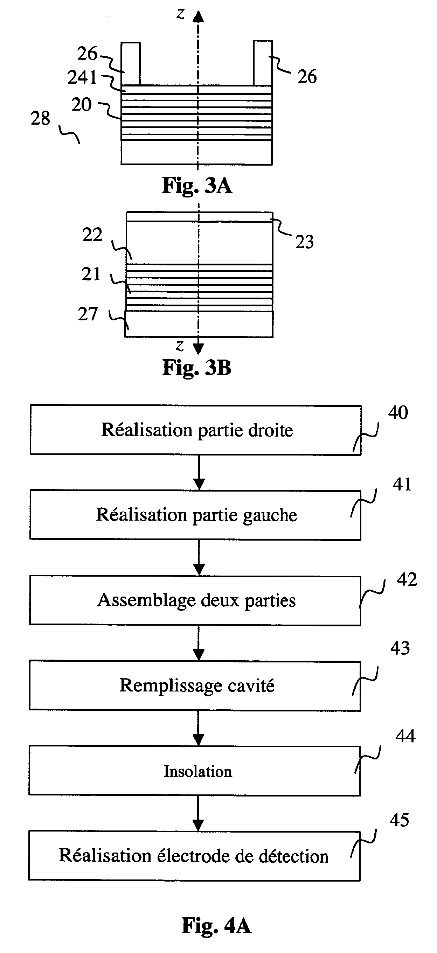

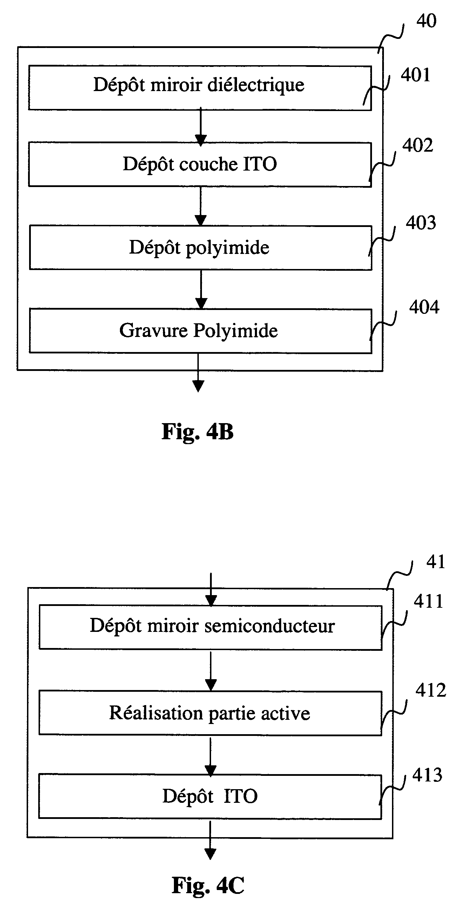

La **figure 3A** décrit plus précisément l'extrémité comprenant la cavité 25 remplie de nano-PDLC du photodétecteur 10 par laquelle se fait la réception du faisceau lumineux et la **figure 4B** son mode de réalisation.

La réalisation 40 de cette extrémité du composant (partie gauche sur la figure 2A) se fait en plusieurs étapes.

Au cours d'une première étape 401, le miroir 20 de Bragg diélectrique est déposé sur une plaque de verre 28 de qualité optique par dépôt sous vide.

Ensuite, au cours d'une étape 402, une couche fine d'ITO constituant la première électrode permettant la polarisation de la couche de nano-PDLC est déposée.

Selon une variante décrite précédemment qui permet de détecter indépendamment plusieurs longueurs d'onde la couche d'ITO est gravée pour permettre la réalisation d'électrodes circulaires (en remplacement de l'électrode 24) que l'on peut polariser indépendamment.

Ensuite, au cours d'une étape 403, une couche sacrificielle 26 de polyimide est déposée à la tournette avec une épaisseur contrôlée à moins de 2% près.

Puis, au cours d'une étape 404, cette couche est attaquée par gravure sélective de manière à laisser des plots permettant ensuite de plaquer cette partie à la seconde partie du photodétecteur 10 en faisant apparaître un espace d'épaisseur contrôlé à moins de 2% près dans la cavité qui pourra être remplie de nano-PDLC.

La **figure 3B** décrit plus précisément l'extrémité opposée du photodétecteur 10 et la **figure 4C** son mode de réalisation.

La réalisation 41 de l'extrémité comprenant la zone 22 comprenant le Bragg semiconducteur 21 (partie droite sur la figure 2A) se fait également en plusieurs étapes.

Au cours d'une première étape 411, le Bragg semiconducteur est fabriqué par dépôt sous vide et successif des paires (épitaxie) sur un substrat d'InP 30.

Ensuite, au cours d'une étape 412, on fait croître grâce par épitaxie la partie active 22 du composant.

Puis, au cours d'une étape 413, une couche fine d'ITO constituant l'électrode 23 reliée à la masse 15 est déposée.

La **figure 4A** décrit plus globalement la réalisation du photodétecteur 10.

Au cours des deux premières étapes 40 et 41, on réalise les deux parties du composant comme illustré en regard des figures 4B et 4C.

Puis, au cours d'une étape 42, on plaque les deux parties du composant ainsi réalisées.

Ensuite, au cours d'une étape 43, on remplit la cavité formée par assemblage des deux parties, de mélange de cristal liquide et de polymère liquide.

Puis, au cours d'une étape 44 on effectue une insolation du mélange pour faire polymériser le polymère et ainsi former les gouttelettes de crystal liquide dans la matrice solidifiée de polymère (nano-PDLC) qui colle les deux parties du photodétecteur.

En effet, le procédé de fabrication de la zone de phase variable nécessite l'insolation UV (ultra-violet) du mélange cristal liquide/polymère placé dans la cavité 25 à travers le miroir de Bragg diélectrique 20. La puissance UV notée $P_{UV}$ utilisée contrôle la taille des gouttelettes de cristal liquide dispersées dans la matrice de polymère et donc la valeur du coefficient de perte associé à la diffusion dans la zone de phase.

Puis, au cours d'une étape 45, après attaque chimique sélective du substrat 30, une couche de métal (préférentiellement d'or) est déposée sur le miroir de Bragg 21 pour former l'électrode 27.

Selon une variante décrite précédemment qui permet de détecter indépendamment plusieurs longueurs d'onde, la couche de métal est gravée pour permettre la réalisation de plusieurs électrodes de détection circulaires (en remplacement de l'électrode 27) chacune des électrodes de détection étant en face (suivant la direction de la l'axe z) d'une électrode correspondante permettant d'accorder la longueur d'onde. On peut ainsi réaliser une matrice de composants indépendants ou un composant détectant plusieurs longueurs d'ondes.

## Description d'un système de demultiplexage selon l'invention.

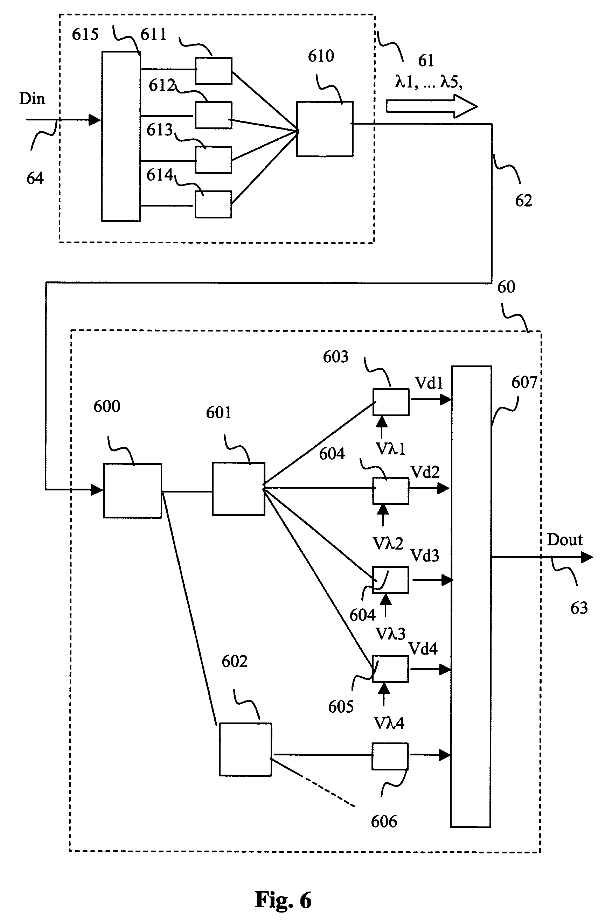

La **figure 6** illustre un système de communication mettant en oeuvre plusieurs photodétecteurs 10 tels que présentés en regard des figures précédentes.

Le système de communication comprend un émetteur optique 61, un récepteur optique 60 et une liaison optique 62 (par exemple une fibre optique).

Le récepteur 60 reçoit un signal optique comprenant plusieurs longueurs d'onde multiplexée via la liaison 62 et émet sur une sortie 63 un signal numérique *Dout* décodé correspondant au signal optique reçu. Il comprend notamment :

- des coupleurs 600 à 602 permettant de dupliquer un signal optique d'entrée sur plusieurs sorties ;
- des photodétecteurs 603 à 606 du même type que le photodétecteur 10 ; et
- une unité de traitement 607.

Le coupleur 600 possède deux sorties connectées respectivement aux entrées des coupleurs 601 et 602. Le coupleur 601 (respectivement 602) possède quatre sorties connectées respectivement à l'entrée des photodétecteurs 603 à 605 (respectivement 606).

Ainsi, chacun des photodétecteurs 603 à 606 reçoit en entrée un faisceau optique similaire au faisceau transitant sur la liaison 62.

Chacune des électrodes de polarisation 24 des photodétecteurs 603 à 606 est reliée à un potentiel $V_{nPDLC}$ différent permettant aux photodétecteurs 603 à 606 de détectées des faisceaux optiques de longueurs d'onde distincte. Ainsi, par exemple, les photodétecteurs 603, 604 et 605 sont reliés respectivement à des potentiels $V_{nPDLC1}$, $V_{nPDLC2}$ et $V_{nPDLC3}$ valant respectivement 0 V, 21 V et 45 V. Ils détectent donc des signaux de longueur d'onde respective 1555 nm, 1550 nm et 1545 nm (Cf courbes de la figure 5).

La sortie de chacun des photodétecteurs 603 à 606 présente donc un courant dépendant de la composante du signal d'entrée associée à la longueur d'onde correspondante du photodétecteur. Il est relié à l'unité de traitement 607 qui convertit le résultat fourni par chacun des photodétecteurs en le signal numérique *Dout,* selon un mode prédéterminé (transmission sur liens physiques distincts, multiplexage temporel, fréquentiel, ...).

Le récepteur 60 permet donc de décoder le signal optique incident d'une manière souple, fiable et rapide. Il est donc particulièrement bien adapté aux communications à haut débit. En outre, il est facilement configurable en fonction du nombre de canaux (chacun des canaux correspondant à une longueur d'onde déterminée).

L'émetteur 61 accepte sur une entrée 64 un signal numérique *Din* pour émettre un signal optique représentatif du signal *Din* sur la liaison 62.

L'émetteur comprend une unité de démultiplexage numérique 615 en charge de transmettre à des lasers émetteurs 611 à 614 une partie du signal *Din* incident. Chacun des lasers 611 à 614 émet à une longueur d'onde différente un signal correspondant aux données d'entrée et alimente un coupleur 610 qui émet, sur la liaison 62, le signal optique résultant des différents signaux produits par chacun des lasers 611 à 614.

En résumé, le signal numérique *Din* est transmis par l'émetteur 61 sur la liaison 62 sous forme d'un faiceau optique. Ce dernier est reçu par le récepteur 60 qui le traite pour produire un signal numérique résultant *Dout* qui, en l'absence d'erreur de transmission, correspond au signal d'entrée *Din*.

Selon le mode de réalisation, les potentiels d'accordabilité des photodétecteurs 603 à 606 sont fixés par une configuration initiale.

Selon une variante de l'invention, les potentiels d'accordabilité varient de manière dynamique sous le contrôle, par exemple, de l'unité de traitement 607 ou de tout autre moyen de commande. Des moyens de commandes peuvent notamment agir sur les potentiels d'accordabilité pour :

- une adaptation aux différents émetteurs succeptibles d'émettre des signaux vers le récepteur 60 ;
- une réception d'un signal optique correspondant à une ou plusieurs fréquences déterminés (par avance ou par protocole de communication) ;
- un calage précis sur une longueur d'onde donnée en fonction des dérives mesurées (le potentiel d'accordabilité étant déterminé pour correspondre à un maximum de sensibilité (pic de spectre) du signal reçu à la longueur d'onde de référence).

Selon une variante du récepteur, plusieurs photodétecteurs sont regroupés en un seul composant selon une variante permettant à un photodétecteur de détecter plusieurs longueurs d'ondes indépendamment les unes des autres (il s'agit par exemple du photodétecteur à plusieurs électrodes de polarisation et de détection, tel qu'illustré précédemment).

D'autres applications du photodétecteur 10 sont envisagées, notamment l'optimisation d'un système de démultiplexage en longueur d'onde (de type par exemple AWG). Selon un premier mode de réalisation, un ou plusieurs photodétecteurs 10 sont placés aux sorties d'un démultiplexeur de bande spectrale large pour sélectionner plus finement en longueur d'onde les canaux. Selon un second mode de réalisation, un ou plusieurs photodétecteurs 10 sont placés aux sorties d'un démultiplexeur de fonction de transfert sélective spectralement mais pas plate. Ainsi, par multiplication des fonctions de transfert du démultiplexeur et du (ou des) photodétecteurs adapté(s), on obtient une fonction de transfert global plate. Ainsi, ces deux modes de réalisation permettent de filtrer un signal optique.

Bien entendu, l'invention n'est pas limitée aux exemples de réalisation mentionnés ci-dessus.

En particulier, l'homme du métier pourra apporter toute variante dans la forme de la structure du photodétecteur, la composition de la zone à indice variable.

De même, le mode de fabrication n'est pas limité au mode décrit mais s'étend à tout mode de fabrication permettant l'association d'un photodétecteur et d'un matériau électro-optique préférentiellement isotrope suivant un plan perpendiculaire à la propagation du ou des faisceaux lumineux et pouvant être soumis à au moins un champ électrique suivant l'axe de propagation du ou des faisceaux lumineux.

L'invention s'applique également au cas où la zone électro-optique est composée d'un matériau qui n'est pas du nano PDLC, tout en possédant des propriétés électro-optique isotropes dans un plan transverse.

L'invention s'applique bien sûr, également au cas où les électrodes ont des géométries différentes de celles décrites, (dès lors qu'elles permettent d'appliquer un champ électrique de polarisation parallèle à l'axe de propagation du faisceau incident) et/ou sont constituées d'un matériau transparent ou semi-transparent pour le faisceau incident, sans être de type ITO.

En outre, l'invention peut s'appliquer au cas où les autres parties du photodétecteur sont différentes de celles du mode de réalisation décrit, notamment pour la zone absorbante ou les extrémités. Celles-ci pourront, notamment, être dans un matériau différent de la fibre ou du substrat de verre et qui seront notamment transparents ou quasi transparents à l'extrémité (ou aux extrémités) par laquelle se fait la réception d'un faisceau optique.

Selon l'invention, les miroirs de Bragg par exemple ne sont pas nécessairement des DBR diélectriques, mais peuvent également être des DBR semiconducteurs ou vice-versa.

De plus, l'invention s'applique non seulement au cas où le composant est couplé à une ou plusieurs fibres directement (le composant est alors suffisamment proche de la ou des fibres pour que l'effet de diffraction de l'air soit négligeable) ou avec une interface comprenant un ou plusieurs collimateurs (sous forme de réseau optique ou de lentille de couplage) mais aussi à tout autre médium de réception d'un faisceau incident, tel que, notamment, l'air libre.

Selon des variantes de réalisation de l'invention, on remplace la zone absorbante par une zone à puits quantique. Cependant, une zone absorbante offre un meilleur recouvrement (et donc le photodétecteur correspondant a un meilleur rendement) qu'une zone à puits quantiques.

L'homme du métier pourra également apporter toute variante dans les moyens permettant de créer les potentiels pour la photodétection et/ accorder le photodétecteur. Ainsi, les électrodes transparentes peuvent être remplacées, par exemple, par des électrodes annulaires placées autour du photodétecteur pour créer les champs électriques de photodétection et/ou d'accordabilité.

Selon des modes de réalisation particulier, le photodétecteur permet un fonctionnement en monomode transverse : à l'intérieur de la cavité du photodétecteur, au moins un élément optique, possède un profil de perte optique variable dans un plan perpendiculaire à un axe de propagation d'un faisceau lumineux (ou plan transverse) traversant la cavité de sorte à favoriser un mode transverse du photodétecteur. Ainsi, le photodétecteur possède, par exemple, dans un plan transverse un profil qui favorise le mode transverse fondamental au détriment des autres modes transverses ou au contraire le premier mode transverse au détriment du mode transverse fondamental. Ainsi, on obtient une meilleure immunité au bruit si le faisceau reçu à décoder fonctionne sur un seul mode transverse. Ce profil permet donc de favoriser soit le mode transverse fondamental soit un autre mode d'une manière souple et simple à réaliser. Pour réaliser, le profil variable, on peut notamment insoler différemment la zone proche de l'axe du photodétecteur et la zone plus éloignée : ainsi, la zone à phase variable contient deux zones concentriques, par exemple, de diamètres respectifs 100 $\mu$m et 4 $\mu$m, le profil binaire présentant une discontinuité dans la taille de gouttelettes entre les deux zones. La première zone centrale de rayon $w$ valant 2 $\mu$m comprend des gouttelettes de diamètre proche de 100 nm plus faible que le diamètre des gouttelettes comprises dans la seconde zone qui est voisin de 500 nm.

L'invention, suivant ses différents modes de réalisation, trouve des applications dans le domaine des télécommunications (notamment dans la transmission de données à faible ou fort débit, dans la transmission de données sur fibres multimodes...) mais également dans de nombreux autres domaines mettant en oeuvre des photodétecteurs (notamment en médecine).

Le photodétecteur selon l'invention peut notamment être utilisé en tant que récepteur de données ou filtre et/ou être couplé à des moyens de démultiplexage, d'amplication, de remise en forme de signaux optiques...

## Revendications

1. Photodétecteur (10, 60) à cavité verticale résonnante comprenant un premier (20) et un second (21) moyens de réflexion formant ladite cavité et des moyens d'absorption (22) de photons d'un faisceau lumineux incident (17), **caractérisé en ce qu'**il comprend, en outre, à l'intérieur de ladite cavité, au moins un élément électro-optique comprenant un matériau isotrope dans un plan transverse, destiné à accorder la longueur d'onde dudit photodétecteur.

2. Photodétecteur selon la revendication 1, **caractérisé en ce qu'**il comprend, en outre, des premiers moyens d'application (24, 23) d'un champ électrique variable audit élément électro-optique en fonction d'au moins une tension électrique appliquée audit photodétecteur.

3. Photodétecteur selon la revendication 2, **caractérisé en ce que** les premiers moyens d'application d'un champ électrique comprennent au moins une première électrode transparente ou semi-transparente (24, 23) permettant l'application dudit champ électrique auxdits éléments électro-optiques et le passage dudit faisceau lumineux incident au travers de ces électrodes.

4. Photodétecteur selon la revendication 3, **caractérisé en ce que** ladite ou lesdites premières électrodes sont de type ITO.

5. Photodétecteur selon l'une quelconque des revendications 1 à 4, **caractérisé en ce qu'**au moins un desdits éléments électro-optiques comprend un matériau de type nano-PDLC.

6. Photodétecteur selon l'une quelconque des revendications 1 à 5, **caractérisé en ce que** lesdits moyens d'absorption de photons comprennent une zone absorbante massive.

7. Photodétecteur selon l'une quelconque des revendications 1 à 6, **caractérisé en ce qu'**il comprend des seconds moyens (27, 23) d'application d'un champ électrique à ladite zone absorbante.

8. Photodétecteur selon la revendication 1 à 7, **caractérisé en ce que** ledit au moins un élément électro-optique possède un profil de perte optique variable dans un plan perpendiculaire à un axe de propagation dudit faisceau lumineux de sorte à favoriser un mode transverse dudit photodétecteur.

9. Matrice de composants **caractérisé en ce que** ladite matrice comprend au moins deux photodétecteurs selon l'une quelconque des revendications 1 à 8.

10. Matrice de composants selon la revendication 9 **caractérisé en ce que** chaque photodétecteur de ladite matrice comprend :

   - des moyens d'application d'un champ électrique permettant d'accorder une longueur d'onde associée audit photodétecteur, de sorte que ladite matrice est apte à accorder une pluralité de longueurs d'onde ;
   - et des moyens de détection associés à chacune des longueurs d'onde accordées.

11. Système de télécommunications à haut débit, **caractérisé en ce qu'**il comprend des moyens de réception (60) d'au moins un faisceau incident comprenant eux-mêmes au moins un photodétecteur à cavité verticale résonnante selon l'une quelconque des revendications 1 à 8.

12. Système selon la revendication 11, **caractérisé en ce que** lesdits moyens de réception comprennent des moyens de redirection (600, 601, 602) d'un faisceau incident vers chacun desdits photodétecteurs.

13. Système selon la revendication 12, **caractérisé en ce que** lesdits moyens de redirection forment un coupleur (600, 601, 602).

14. Système selon l'une quelconque des revendications 11 à 13, **caractérisé en ce que** lesdits moyens de réception comprennent au moins deux photodétecteurs (603 à 606) adaptés à détecter des faisceaux lumineux de longueurs d'onde distinctes.

15. Système selon la revendication 11 à 14, **caractérisé en ce qu'**il comprend des moyens d'émission (61) dudit au moins un faisceau incident.

10

λ

z

17

14 V$_{nPDLC}$

15

16

V$_{dét}$

**Fig. 1**

10

28

20

25

26

23

220

22

221

21

27

Bragg DiEl.

PDLC

*dInP*

Zone absorbante

*di*

*dInP*

Bragg SemiC.

z

mλ/2

pλ/2

17

24

14

V$_{nPDLC}$

15

26

16

V$_{det}$

**Fig. 2**

**Fig. 3A**

**Fig. 3B**

| Réalisation partie droite | 40 |

↓

| Réalisation partie gauche | 41 |

↓

| Assemblage deux parties | 42 |

↓

| Remplissage cavité | 43 |

↓

| Insolation | 44 |

↓

| Réalisation électrode de détection | 45 |

**Fig. 4A**

40

| Dépôt miroir diélectrique | 401 |
| Dépôt couche ITO | 402 |
| Dépôt polyimide | 403 |
| Gravure Polyimide | 404 |

**Fig. 4B**

41

| Dépôt miroir semiconducteur | 411 |
| Réalisation partie active | 412 |
| Dépôt ITO | 413 |

**Fig. 4C**

**Fig. 5**

**Fig. 6**